# EUROPEAN PATENT APPLICATION

(11) **EP 4 600 790 A1**
(43) Date of publication of application: **13.08.2025**
(21) Application number: 23881238.2
(22) Date of filing: 12.06.2023
(51) Int. Cl.: G06F 3/041

(54) **ELECTRONIC DEVICE**

(30) Priority: 25.10.2022 CN 202211314271
(71) Applicant: Huawei Technologies Co., Ltd., Shenzhen, Guangdong 518129 (CN)
(72) Inventor: MIN, Yancan, Shenzhen, Guangdong 518129 (CN)
(74) Representative: Goddar, Heinz J.
(86) International application number: PCT/CN2023/099688
(87) International publication number: WO 2024/087647

(57) **Abstract**

Embodiments of this application provide an electronic device, and relate to the field of display technologies, to resolve a problem of matching a non-volatile memory with a timing controller and a touch integrated circuit. The electronic device includes a touch display panel, and the touch display panel has touch and display functions. The electronic device further includes the timing controller and the touch integrated circuit. The timing controller is configured to provide a timing control signal for the touch display panel, and the touch integrated circuit is configured to provide a touch signal for the touch display panel. The electronic device further includes a circuit board and the non-volatile memory. The circuit board is coupled to the touch display panel, and the touch integrated circuit is disposed on the circuit board. The non-volatile memory is disposed outside the touch integrated circuit, and the non-volatile memory is configured to provide a non-volatile storage function for both the timing controller and the touch integrated circuit. In other words, in the electronic device provided in embodiments of this application, no non-volatile memory is integrated into the touch integrated circuit.

## Description

This application claims priority to Chinese Patent Application No. 202211314271.5, filed with the China National Intellectual Property Administration on October 25, 2022 and entitled "ELECTRONIC DEVICE", which is incorporated herein by reference in its entirety.

### TECHNICAL FIELD

This application relates to the field of display technologies, and in particular, to an electronic device.

### BACKGROUND

With development of display technologies, electronic devices with display functions become indispensable electronic tools in people's daily life.

In a current mainstream organic light-emitting diode (organic electro-luminescence display, OLED) electronic device, a timing controller configured to provide a timing control signal for the electronic device and a touch integrated circuit configured to provide a touch signal for the electronic device are two independent structures. During working, both the timing controller and the touch integrated circuit need to access a non-volatile memory, to output the timing control signal and the touch signal.

Therefore, resolving a problem of matching the non-volatile memory with the timing controller and the touch integrated circuit is always a research hotspot in the art.

### SUMMARY

Embodiments of this application provide an electronic device, to resolve a problem of matching a non-volatile memory with a timing controller and a touch integrated circuit.

To achieve the foregoing objective, this application uses the following technical solutions.

According to a first aspect of embodiments of this application, an electronic device is provided. The electronic device is, for example, an electronic device with a touch function. The electronic device includes a touch display panel, and the touch display panel has touch and display functions. The electronic device further includes a timing controller and a touch integrated circuit. The timing controller is configured to provide a timing control signal for the touch display panel, and the touch integrated circuit is configured to provide a touch signal for the touch display panel. The electronic device further includes a circuit board and a non-volatile memory. The circuit board is coupled to the touch display panel, and the touch integrated circuit is disposed on the circuit board. The non-volatile memory is disposed outside the touch integrated circuit, and the non-volatile memory is configured to provide a non-volatile storage function for both the timing controller and the touch integrated circuit. In other words, in the electronic device provided in embodiments of this application, no non-volatile memory is integrated into the touch integrated circuit.

In the electronic device provided in embodiments of this application, the timing controller and the touch integrated circuit are jointly designed, and share the same non-volatile memory, and the non-volatile memory is disposed outside the touch integrated circuit. No flash memory needs to be disposed in the touch integrated circuit, and a non-volatile storage requirement of the touch integrated circuit is satisfied by the non-volatile memory coupled to the timing controller. Therefore, this resolves a problem that the touch integrated circuit cannot be prepared independently because a specific technology compatible with a flash memory preparing process needs to be used to integrate a flash memory into the touch integrated circuit. In addition, no flash memory needs to be integrated into the touch integrated circuit, and a problem that the touch integrated circuit cannot be independently prepared because the flash memory needs to be purchased can also be resolved. In addition, a current mainstream electronic device includes a non-volatile memory coupled to the timing controller. In the electronic device provided in embodiments of this application, it is equivalent to reusing the non-volatile memory for the touch integrated circuit, and a technology for the electronic device is not changed too much. In comparison with the mainstream electronic device with an additional flash memory integrated into the touch integrated circuit, the electronic device provided in embodiments of this application has low preparation costs.

In a possible implementation, the electronic device further includes an arbitration controller. The arbitration controller is configured to schedule the timing controller or the touch integrated circuit to communicate with the non-volatile memory. The timing controller and the touch integrated circuit share the non-volatile memory in a time-sharing manner by using the arbitration controller. A principle is simple and implementation is easy.

In a possible implementation, the arbitration controller is configured to: determine whether the timing controller accesses the non-volatile memory; and when the timing controller accesses the non-volatile memory, block the touch integrated circuit from communicating with the non-volatile memory; or when the timing controller does not access the non-volatile memory, schedule the touch integrated circuit to communicate with the non-volatile memory. An arbitration function of the arbitration controller is implemented by using digital logic. A structure is simple.

In a possible implementation, the electronic device includes a display driver integrated circuit. The timing controller and/or the arbitration controller are/is integrated into the display driver integrated circuit. This application is applicable to an electronic device with high integration, for example, a mobile phone or a wearable device.

In a possible implementation, the timing controller is disposed on the circuit board, and the arbitration controller is integrated into the timing controller. This application is applicable to an electronic device with relatively low integration, for example, a notebook computer or a tablet computer.

In a possible implementation, the electronic device further includes an enable control line. The enable control line is configured to select and enable the timing controller or the touch integrated circuit to perform signal transmission with the non-volatile memory. The timing controller and the touch integrated circuit share the non-volatile memory in a time-sharing manner by using the enable control line. A structure is simple and implementation is easy.

In a possible implementation, the electronic device includes a display driver integrated circuit, and the timing controller is integrated into the display driver integrated circuit; the display driver integrated circuit has a first communication interface, the touch integrated circuit has a second communication interface, and the non-volatile memory is coupled to the first communication interface and the second communication interface; and two ends of the enable control line are coupled to the display driver integrated circuit and the touch integrated circuit, and the enable control line includes a first control line and a second control line; and when the first control line is valid, the display driver integrated circuit controls the first communication interface to be in a high-impedance state; or when the second control line is valid, the touch integrated circuit controls the second communication interface to be in a high-impedance state. In this solution, a structure is simple, and structures of the display driver integrated circuit and the touch integrated circuit do not need to be changed. This is easy to implement.

In a possible implementation, the first communication interface and the second communication interface perform wire-AND. In this way, the non-volatile memory may be coupled to both the first communication interface and the second communication interface through one communication interface, thereby reducing a quantity of communication interfaces on the non-volatile memory.

In a possible implementation, the timing controller is disposed on the circuit board; the timing controller has a third communication interface, the touch integrated circuit has a fourth communication interface, and the non-volatile memory is coupled to the third communication interface and the fourth communication interface; and two ends of the enable control line are coupled to the timing controller and the touch integrated circuit, and the enable control line includes a third control line and a fourth control line; and when the third control line is valid, the timing controller controls the third communication interface to be in a high-impedance state; or when the fourth control line is valid, the touch integrated circuit controls the fourth communication interface to be in a high-impedance state. In this solution, a structure is simple, and structures of the timing controller and the touch integrated circuit do not need to be changed. This is easy to implement.

In a possible implementation, the third communication interface and the fourth communication interface perform wire-AND. In this way, the non-volatile memory may be coupled to both the third communication interface and the fourth communication interface through one communication interface, thereby reducing a quantity of communication interfaces on the non-volatile memory.

In a possible implementation, the first communication interface, the second communication interface, the third communication interface, and the fourth communication interface are all serial peripheral interfaces. This is a possible implementation.

In a possible implementation, the non-volatile memory includes a flash memory. In this way, an existing flash memory in the mainstream electronic device may be used as the non-volatile memory of the electronic device in embodiments of this application, and a change to the electronic device is small.

In a possible implementation, the non-volatile memory is disposed on the circuit board. In this way, the existing flash memory in the mainstream electronic device may be used as the non-volatile memory of the electronic device in embodiments of this application, and a change to the electronic device is small.

In a possible implementation, the electronic device includes a display driver integrated circuit. The timing controller and the non-volatile memory are integrated into the display driver integrated circuit. In this way, the non-volatile memory may be directly formed when the display driver integrated circuit is formed, so that integration can be improved, and a connection between the timing controller and the non-volatile memory is simplified.

In a possible implementation, the timing controller is disposed on the circuit board, and the non-volatile memory is integrated into the timing controller. In this way, the non-volatile memory may be directly formed when the timing controller is formed, so that integration can be improved, and a connection between the timing controller and the non-volatile memory is simplified.

In a possible implementation, the electronic device further includes a protocol converter. The protocol converter is configured to match a communication interface of the touch integrated circuit with a communication interface of the non-volatile memory. The protocol converter is disposed, so that a type requirement on a connection interface between the touch integrated circuit and the non-volatile memory can be reduced, to be applicable to an existing touch integrated circuit and an existing non-volatile memory.

In a possible implementation, the touch integrated circuit includes a serial peripheral interface, and the non-volatile memory includes a memory interface. The serial peripheral interface is coupled to the memory interface through the protocol converter. This is an implementation.

In a possible implementation, the protocol converter is integrated into the display driver integrated circuit or the timing controller. This is an implementation.

In a possible implementation, the non-volatile memory includes a first non-volatile storage area and a second non-volatile storage area. The first non-volatile storage area is configured to provide a non-volatile storage function for the timing controller, and the second non-volatile storage area is configured to provide a non-volatile storage function for the touch integrated circuit. This is an implementation with a simple structure.

In a possible implementation, the electronic device is an organic light-emitting diode electronic device. Embodiments of this application can resolve a problem of sharing a non-volatile memory by a timing controller and a touch integrated circuit in the organic light-emitting diode electronic device.

### BRIEF DESCRIPTION OF DRAWINGS

FIG. 1A is a diagram of a framework of an electronic device according to an embodiment of this application;
FIG. 1B is a layout diagram of an electronic device according to an embodiment of this application;
FIG. 1C is a layout diagram of another electronic device according to an embodiment of this application;
FIG. 2A is a diagram of an internal structure of a touch integrated circuit according to an embodiment of this application;
FIG. 2B is a diagram of an internal structure of another touch integrated circuit according to an embodiment of this application;
FIG. 3A is a layout diagram of an electronic device according to an embodiment of this application;
FIG. 3B is a layout diagram of another electronic device according to an embodiment of this application;
FIG. 4 is a layout diagram of another electronic device according to an embodiment of this application;
FIG. 5 is a layout diagram of another electronic device according to an embodiment of this application;
FIG. 6 is a layout diagram of another electronic device according to an embodiment of this application;
FIG. 7 is a layout diagram of another electronic device according to an embodiment of this application;
FIG. 8 is a layout diagram of another electronic device according to an embodiment of this application; and
FIG. 9 is a layout diagram of another electronic device according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second" below are only for ease of description, and cannot be understood as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more than two.

In addition, in embodiments of this application, orientation terms such as "upper", "lower", "left", and "right" may include but are not limited to definitions based on illustrated orientations in which components in the accompanying drawings are placed. It should be understood that, these direction terms may be relative concepts. The orientation terms are used for relative description and clarification, and may vary accordingly depending on a change in the orientations in which the components in the accompanying drawings are placed in the accompanying drawings.

In embodiments of this application, unless otherwise clearly specified and limited, the term "connection" should be understood in a broad sense. For example, the "connection" may indicate a fixed connection, a detachable connection, or an integral connection; or may indicate direct interconnection, or indirect interconnection through an intermediate medium. In addition, the term "coupling" may indicate a direct electrical connection, or may indicate an indirect electrical connection through an intermediate medium. The term "contact" may indicate direct contact or indirect contact through an intermediate medium.

In embodiments of this application, the term "and/or" describes an association relationship between associated objects and may indicate that three relationships exist. For example, A and/or B may indicate the following cases: Only A exists, both A and B exist, and only B exists, where A and B may be singular or plural. The character "/" generally indicates an "or" relationship between the associated objects.

Embodiments of this application provide an electronic device. The electronic device is, for example, a consumer electronic product, a home electronic product, a vehicle-mounted electronic product, a financial terminal product, or a communication electronic product with a touch function. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, an intelligent wearable product (for example, a smart watch or a smart band), a virtual reality (virtual reality, VR) terminal device, an augmented reality (augmented reality, AR) terminal device, or an uncrewed aerial vehicle. The home electronic product is, for example, a smart door lock, a television, a remote control, a refrigerator, or a small household rechargeable appliance (for example, a soy milk maker or a robot vacuum cleaner). The vehicle-mounted electronic product is, for example, a vehicle-mounted navigator or a vehicle-mounted high-density digital video disc (digital video disc, DVD). The financial terminal product is, for example, an automated teller machine (automated teller machine, ATM) (machine), or a terminal for self-service business handling. The communication electronic product is, for example, a communication device such as a server, a non-volatile memory, a radar, or a base station.

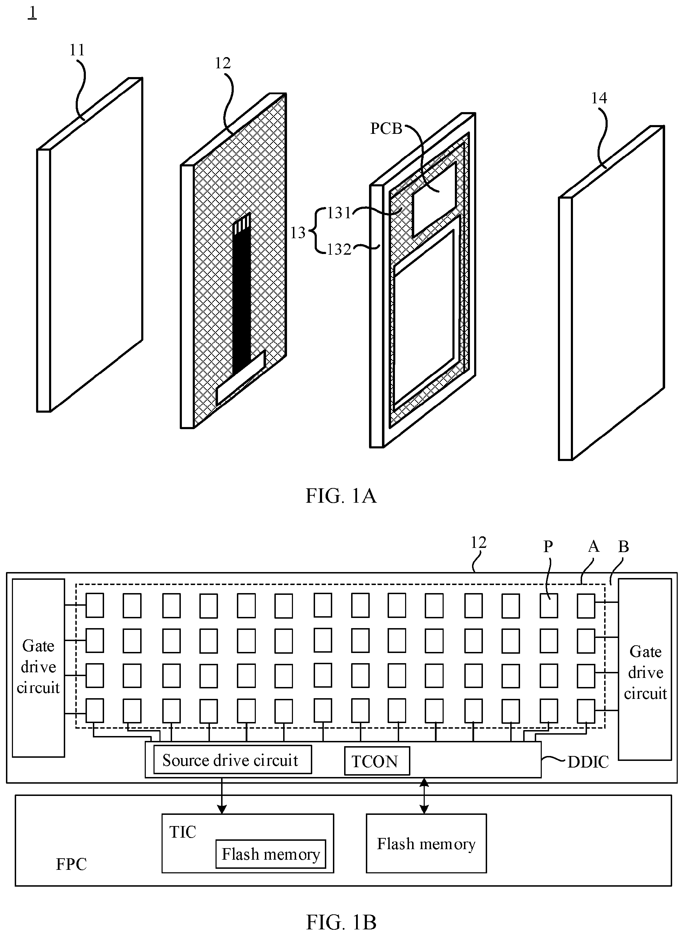

For ease of description, the following uses an example in which the electronic device is a mobile phone for description. As shown in FIG. 1A, an electronic device 1 mainly includes a cover plate 11, a touch display panel 12, a middle frame 13, and a rear housing 14. The rear housing 14 and the touch display panel 12 are respectively located on two sides of the middle frame 13, the middle frame 13 and the touch display panel 12 are disposed in the rear housing 14, the cover plate 11 is disposed on a side that is of the touch display panel 12 and that is away from the middle frame 13, and a display surface of the touch display panel 12 faces the cover plate 11.

The touch display panel 12 may be a liquid crystal display (liquid crystal display, LCD). In this case, the liquid crystal display includes a liquid crystal touch display panel and a backlight module. The liquid crystal touch display panel is disposed between the cover plate 11 and the backlight module, and the backlight module is configured to provide a light source for the liquid crystal touch display panel. The touch display panel 12 may alternatively be an organic light-emitting diode (organic light-emitting diode, OLED) display. Because the OLED display is a self-luminous display, no backlight module needs to be disposed.

The middle frame 13 includes a bearing plate 131 and a side frame 132 surrounding the bearing plate 131. The electronic device 1 may further include electronic components such as a printed circuit board (printed circuit board, PCB), a battery, and a camera. The electronic components such as the printed circuit board, the battery, and the camera may be disposed on the bearing plate 131.

As shown in FIG. 1B, the touch display panel 12 includes an active area (active area, AA) A and a peripheral area B located around the active area A.

In some embodiments, the active area A of the touch display panel 12 is used as a display area of the electronic device 1, and the peripheral area B of the touch display panel 12 is used as a non-display area of the electronic device 1.

As shown in FIG. 1B, the active area A of the touch display panel 12 includes a plurality of sub-pixels (sub-pixels) P. For ease of description, in this application, descriptions are provided by using an example in which the plurality of sub-pixels P are arranged in a form of matrix. In this case, sub-pixels P arranged in a line in a horizontal direction are referred to as sub-pixels in a same row, and sub-pixels P arranged in a line in a vertical direction are referred to as sub-pixels in a same column.

The electronic device 1 includes a gate drive circuit and a source drive circuit that are located in the peripheral area B of the touch display panel 12. The gate drive circuit is configured to provide a gate drive signal for the sub-pixel P, and the source drive circuit is configured to provide a source drive signal for the sub-pixel P.

For example, the gate drive circuit may be integrated into the touch display panel 12 by using, for example, a gate on array (gate on array, GOA) technology. The gate drive circuit includes a plurality of cascaded shift registers (shift registers, SRs).

There may be one or more gate drive circuits. For example, as shown in FIG. 1B, the electronic device 1 includes two gate drive circuits, and the two gate drive circuits are disposed on two sides of the active area A in the horizontal direction.

For example, the source drive circuit may be integrated into a display driver integrated circuit (display driver integrated circuit, DDIC). For example, the display driver integrated circuit DDIC is directly attached to the touch display panel 12 in a form of die (die).

A touch integrated circuit (touch integrated circuit, TIC) is configured to provide a touch signal for the electronic device 1. The display driver integrated circuit DDIC responsible for display and the touch integrated circuit TIC responsible for touch are two independent chips.

For example, as shown in FIG. 1B, the display driver integrated circuit DDIC is located in the touch display panel 12, and the touch integrated circuit TIC is located on a flexible printed circuit (flexible printed circuit, FPC).

The electronic device further includes a timing controller (timing controller, TCON). In some embodiments, as shown in FIG. 1B, the timing controller TCON is integrated into the display driver integrated circuit DDIC, and the timing controller TCON is configured to provide a timing signal for the gate drive circuit and the source drive circuit in the touch display panel 12.

To resolve a problem of matching a non-volatile memory with a timing controller TCON and a touch integrated circuit TIC, in some technologies, as shown in FIG. 1B, the timing controller TCON in the display driver integrated circuit DDIC is externally connected to an independent flash memory (flash memory), and a flash memory is integrated into the touch integrated circuit TIC.

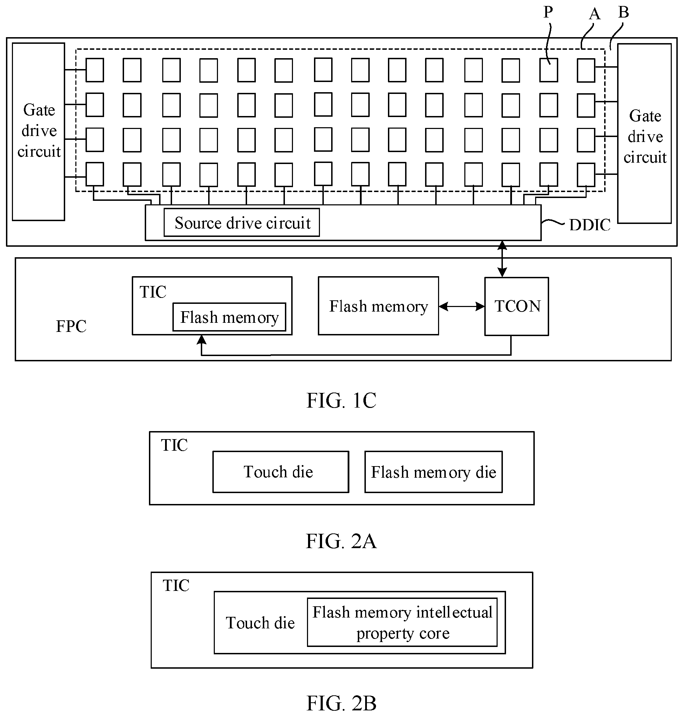

As shown in FIG. 1C, in some electronic devices with large screens, for example, a notebook computer (note book) and a tablet computer (pad), a timing controller TCON is no longer integrated into a display driver integrated circuit DDIC, but is disposed on a flexible printed circuit FPC.

In this case, the display driver integrated circuit DDIC is coupled to the timing controller TCON, and the timing controller TCON is directly coupled to an external flash memory.

In both of an electronic device in which a timing controller TCON is integrated into a display driver integrated circuit DDIC and an electronic device in which a timing controller TCON is disposed on a flexible printed circuit FPC, a flash memory is integrated into a touch integrated circuit TIC.

For a manner of integrating a flash memory into a touch integrated circuit TIC, in some technologies, as shown in FIG. 2A, a touch die and a flash memory die are packaged in a same chip, so that the flash memory is integrated into the touch integrated circuit TIC.

However, in this manner, the flash memory die accounts for about 15% of costs of the touch integrated circuit TIC, and the flash memory die needs to be purchased. This is not conducive to self-preparation.

For a manner of integrating a flash memory into a touch integrated circuit TIC, in some other technologies, as shown in FIG. 2B, when a touch die is prepared, a flash memory intellectual property core is directly integrated into the touch die, so that the flash memory is integrated into the touch integrated circuit TIC.

However, in this manner, a preparing process of an embedded flash memory (eFlash) technology that supports an on-chip flash memory intellectual property core needs to be selected for the touch die. This increases supply difficulty. As a result, preparing costs of the flash memory intellectual property core (IP) account for about 25% of costs of the touch integrated circuit TIC.

In view of this, embodiments of this application further provide an electronic device, to reduce costs of a touch integrated circuit TIC while meeting non-volatile storage requirements of a timing controller TCON and the touch integrated circuit TIC.

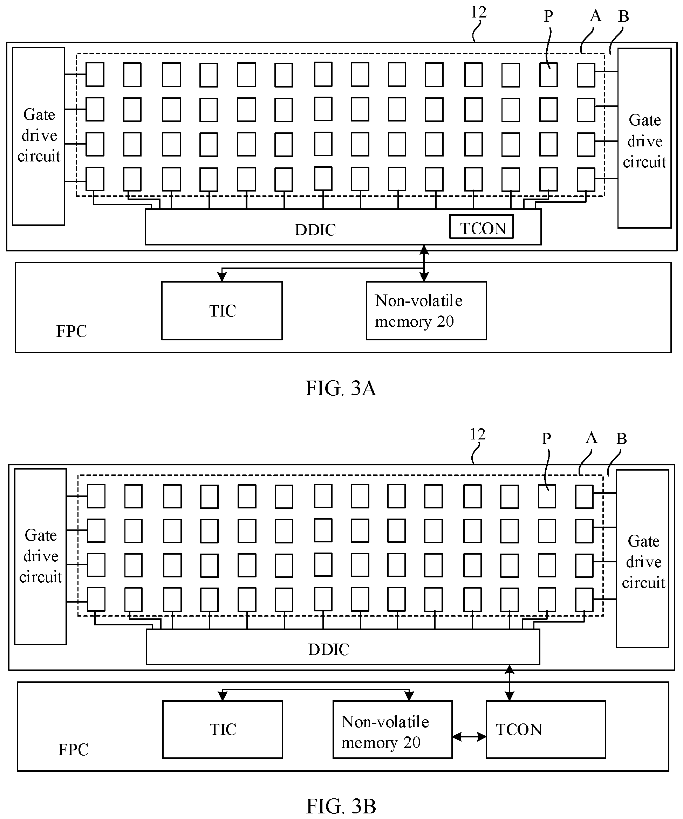

As shown in FIG. 3A, the electronic device includes a touch display panel 12, a display driver integrated circuit DDIC, a timing controller TCON, a touch integrated circuit TIC, a circuit board, and a non-volatile memory 20.

The touch display panel 12 may be any panel with touch and display functions. For example, the touch display panel 12 is an OLED display panel with a touch function.

The display driver integrated circuit DDIC is configured to provide a drive signal for the touch display panel 12. For example, the display driver integrated circuit DDIC is located inside the touch display panel 12 and is attached to a display of the touch display panel.

The timing controller TCON is configured to provide a touch timing control signal for the touch display panel 12. As shown in FIG. 3A, the timing controller TCON is integrated into the display driver integrated circuit DDIC. Alternatively, as shown in FIG. 3B, the timing controller TCON is disposed on the circuit board.

The circuit board is connected to the touch display panel 12 and is configured to implement coupling between the touch display panel 12 and a PCB in the electronic device. The circuit board may be, for example, a flexible printed circuit FPC, or the circuit board may be a circuit board in any form, provided that the circuit board can implement coupling between the display driver integrated circuit DDIC and the PCB. For ease of description, in the following embodiments of this application, an example in which the circuit board is a flexible printed circuit FPC is used for description.

The touch integrated circuit TIC is disposed on the flexible printed circuit FPC and is configured to provide a touch signal for the touch display panel 12.

The non-volatile memory 20 is disposed outside the touch integrated circuit TIC, and the non-volatile memory 20 is configured to provide a non-volatile storage function for both the timing controller TCON and the touch integrated circuit TIC.

Alternatively, it is understood that in this embodiment of this application, the timing controller TCON and the touch integrated circuit TIC share the same non-volatile memory 20, instead of being correspondingly provided with respective flash memories.

Certainly, the non-volatile memory 20 may be reused in a time-sharing manner. That is, at a moment, the non-volatile memory 20 is connected to the timing controller TCON, and at another moment, the non-volatile memory 20 is connected to the touch integrated circuit TIC.

Alternatively, the non-volatile memory 20 may be used by area. That is, an area of the non-volatile memory 20 is connected to the timing controller TCON, and another area of the non-volatile memory 20 is connected to the touch integrated circuit TIC.

Alternatively, the non-volatile memory 20 may be shared in any other form, provided that the non-volatile memory 20 can meet non-volatile storage requirements of both the timing controller TCON and the touch integrated circuit TIC.

In the electronic device provided in embodiments of this application, the timing controller TCON and the touch integrated circuit TIC are jointly designed, and share the same non-volatile memory 20, and the non-volatile memory 20 is disposed outside the touch integrated circuit TIC. No flash memory needs to be disposed in the touch integrated circuit TIC, and a non-volatile storage requirement of the touch integrated circuit TIC is satisfied by the non-volatile memory 20 coupled to the timing controller TCON. In this way, a problem of high costs of the touch integrated circuit TIC caused by integration of a flash memory in the touch integrated circuit TIC is resolved. In addition, no flash memory needs to be integrated into the touch integrated circuit TIC, and a problem that the touch integrated circuit TIC cannot be independently prepared because the flash memory needs to be purchased can also be resolved. In addition, a current mainstream electronic device includes a non-volatile memory 20 coupled to the timing controller TCON. In the electronic device provided in embodiments of this application, it is equivalent to reusing the non-volatile memory 20 for the touch integrated circuit TIC, and a technology for the electronic device is not changed too much. In comparison with the mainstream electronic device with an additional flash memory integrated into the touch integrated circuit TIC, the electronic device provided in embodiments of this application has low preparation costs.

The timing controller TCON in the electronic device being integrated into the display driver integrated circuit DDIC and the timing controller TCON being disposed on the flexible printed circuit FPC are separately described below.

In a possible implementation, the timing controller TCON is integrated into the display driver integrated circuit DDIC. For example, the electronic device is a small electronic device that has a high integration requirement, for example, a mobile phone, a telephone watch, or a band.

### Example 1

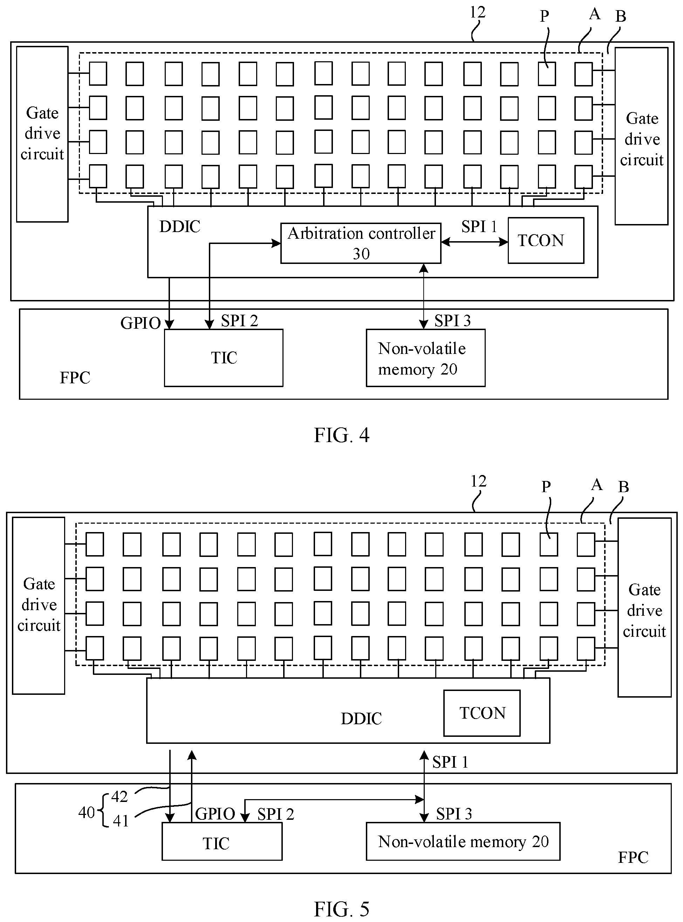

As shown in FIG. 4, an electronic device includes a touch display panel 12, a display driver integrated circuit DDIC, a timing controller TCON, a touch integrated circuit TIC, a flexible printed circuit FPC, and a non-volatile memory 20.

The timing controller TCON is integrated into the display driver integrated circuit DDIC. The non-volatile memory 20 is disposed outside the touch integrated circuit TIC, and the non-volatile memory 20 is configured to provide a non-volatile storage function for both the timing controller TCON and the touch integrated circuit TIC.

In some embodiments, the electronic device further includes an arbitration controller 30. The arbitration controller 30 is configured to schedule the timing controller TCON or the touch integrated circuit TIC to communicate with the non-volatile memory 20.

In this case, the arbitration controller 30 is configured to control the timing controller TCON in the display driver integrated circuit DDIC and the touch integrated circuit TIC to access and be externally connected to the non-volatile memory 20 in a time-sharing manner. Under scheduling of the arbitration controller 30, at a moment, the timing controller TCON communicates with the non-volatile memory 20, or the touch integrated circuit TIC communicates with the non-volatile memory 20. A case in which the timing controller TCON and the touch integrated circuit TIC simultaneously communicate with the non-volatile memory 20 does not occur.

Because the timing controller TCON needs to load content to the non-volatile memory 20 only in a power-on initialization process, after loading is completed, the non-volatile memory 20 is no longer accessed in a subsequent display process. Therefore, when the timing controller TCON is powered on and initialized, the arbitration controller 30 schedules the timing controller TCON to communicate with the non-volatile memory 20; and after the timing controller TCON is powered on and initialized, the arbitration controller 30 schedules the touch integrated circuit TIC to communicate with the non-volatile memory 20. There is no conflict between the timing controller TCON and the touch integrated circuit TIC in time-sharing reuse of the non-volatile memory 20.

In some embodiments, as shown in FIG. 4, the arbitration controller 30 is integrated into the display driver integrated circuit DDIC.

For example, the timing controller TCON has a first serial peripheral interface (serial peripheral interface, SPI) SPI 1, the touch integrated circuit TIC has a second serial peripheral interface SPI 2, and the non-volatile memory 20 has a third serial peripheral interface SPI 3. The timing controller TCON is coupled to the arbitration controller 30 through the first serial peripheral interface SPI 1, the touch integrated circuit TIC is coupled to the arbitration controller 30 in the display driver integrated circuit DDIC through the second serial peripheral interface SPI 2, and the non-volatile memory 20 is coupled to the arbitration controller 30 in the display driver integrated circuit DDIC through the third serial peripheral interface SPI 3, to implement coupling between the non-volatile memory 20 and the arbitration controller 30 in the display driver integrated circuit DDIC.

In this way, the arbitration controller 30 is coupled to the touch integrated circuit TIC, the timing controller TCON, and the non-volatile memory 20. The arbitration controller 30 controls the touch integrated circuit TIC to communicate with the non-volatile memory 20, or the timing controller TCON to communicate with the non-volatile memory 20, to implement time-sharing reuse of the non-volatile memory 20.

For a structure of the arbitration controller 30, in some embodiments, the arbitration controller 30 may be implemented, for example, by using digital logic.

For example, the arbitration controller 30 is configured to: determine whether the timing controller TCON accesses the non-volatile memory 20; and when the timing controller TCON accesses the non-volatile memory 20, block the touch integrated circuit TIC from communicating with the non-volatile memory 20; or when the timing controller TCON does not access the non-volatile memory 20, schedule the touch integrated circuit TIC to communicate with the non-volatile memory 20.

Because the timing controller TCON needs to access the non-volatile memory 20 only in the power-on initialization process (for example, about 60 milliseconds), after power-on initialization, the timing controller TCON no longer needs to access the non-volatile memory 20. Therefore, when determining that the timing controller TCON does not access the non-volatile memory 20, the arbitration controller 30 schedules the touch integrated circuit TIC to communicate with the non-volatile memory 20.

Certainly, the arbitration controller 30 may alternatively be integrated on the flexible printed circuit FPC, and the arbitration controller 30 is coupled to the touch integrated circuit TIC, the display driver integrated circuit DDIC, and the non-volatile memory 20.

In some embodiments, as shown in FIG. 4, the non-volatile memory 20 is disposed on the flexible printed circuit FPC.

For example, the non-volatile memory 20 is a flash memory.

In this way, a flash memory that is in a mainstream electronic device and that is coupled to the display driver integrated circuit DDIC may be used as the non-volatile memory 20 in the electronic device provided in embodiments of this application. A technical change is small, and implementation is easy.

In some embodiments, the display driver integrated circuit DDIC and the touch integrated circuit TIC are further coupled through a general-purpose input/output (general-purpose input/output, GPIO) interface. Signal transmission may or may not be performed on the general-purpose input/output GPIO interface.

In the electronic device provided in embodiments of this application, the timing controller TCON and the touch integrated circuit TIC are jointly designed to share the non-volatile memory 20. No flash memory is integrated into the touch integrated circuit TIC, and the touch integrated circuit TIC accesses the non-volatile memory 20 on the flexible printed circuit FPC by using the second serial peripheral interface SPI 2. The arbitration controller 30 controls the timing controller TCON and the touch integrated circuit TIC to communicate with the non-volatile memory 20 in a time-sharing manner, so that the timing controller TCON and the touch integrated circuit TIC share the non-volatile memory 20, and the timing controller TCON and the touch integrated circuit TIC access the non-volatile memory 20 in a time-sharing manner. In this way, a non-volatile storage requirement of the touch integrated circuit TIC can also be ensured without integration of a flash memory into the touch integrated circuit TIC, to resolve a problem that a cost proportion of the flash memory is high (for example, 15% to 25%) because a specific technology compatible with a flash memory preparing process needs to be used to integrate the flash memory in the touch integrated circuit TIC, and resolve a problem that the touch integrated circuit TIC cannot be independently prepared because the flash memory needs to be purchased.

### Example 2

A main difference between Example 2 and Example 1 lies in that, an arbitration controller 30 is no longer used to control a timing controller TCON and a touch integrated circuit TIC to communicate with a non-volatile memory 20 in a time-sharing manner, but an enable control line is used to control the timing controller TCON and the touch integrated circuit TIC to communicate with the non-volatile memory 20 in a time-sharing manner.

As shown in FIG. 5, an electronic device includes a touch display panel 12, a display driver integrated circuit DDIC, the timing controller TCON, the touch integrated circuit TIC, a flexible printed circuit FPC, and the non-volatile memory 20.

The timing controller TCON is integrated into the display driver integrated circuit DDIC, the non-volatile memory 20 is disposed outside the touch integrated circuit TIC, and the non-volatile memory 20 is configured to provide a non-volatile storage function for both the timing controller TCON and the touch integrated circuit TIC.

In some embodiments, the electronic device further includes the enable control line 40. The enable control line 40 is configured to select and enable the timing controller TCON or the touch integrated circuit TIC to perform signal transmission with the non-volatile memory 20.

In this case, the enable control line 40 is configured to select and enable the timing controller TCON and the touch integrated circuit TIC to access and be externally connected to the non-volatile memory 20 in a time-sharing manner. Under control of an enable signal on the enable control line 40, at a moment, the timing controller TCON communicates with the non-volatile memory 20, or the touch integrated circuit TIC communicates with the non-volatile memory 20. A case in which the timing controller TCON and the touch integrated circuit TIC simultaneously communicate with the non-volatile memory 20 does not occur.

Because the timing controller TCON needs to load content to the non-volatile memory 20 only in a power-on initialization process, after loading is completed, the non-volatile memory 20 is no longer accessed in a subsequent display process. Therefore, when the timing controller TCON is powered on and initialized, the enable control line 40 selects the timing controller TCON to communicate with the non-volatile memory 20; and after the timing controller TCON is powered on and initialized, the enable control line 40 selects the touch integrated circuit TIC to communicate with the non-volatile memory 20. There is no conflict between the timing controller TCON and the touch integrated circuit TIC in time-sharing reuse of the non-volatile memory 20.

In some embodiments, the display driver integrated circuit DDIC has a first communication interface, the touch integrated circuit TIC has a second communication interface, and the non-volatile memory 20 has a fifth communication interface. The non-volatile memory 20 is coupled to the first communication interface and the second communication interface through the fifth communication interface.

The first communication interface, the second communication interface, and the fifth communication interface are used as communication and interconnection interfaces between the touch integrated circuit TIC, the display driver integrated circuit DDIC, and the non-volatile memory 20. Communication connections between the touch integrated circuit TIC, the display driver integrated circuit DDIC, and the non-volatile memory 20 may be implemented through interconnection between the first communication interface, the second communication interface, and the fifth communication interface.

In this embodiment of this application, the first communication interface, the second communication interface, and the fifth communication interface have a function of being in a high-impedance (high-impedance) state.

The high-impedance state indicates that a node in a circuit has higher impedance than other points in the circuit.

For example, the first communication interface, the second communication interface, and the fifth communication interface are all serial peripheral interfaces. For example, as shown in FIG. 5, the first communication interface is a first serial peripheral interface SPI 1, the second communication interface is a second serial peripheral interface SPI 2, and the fifth communication interface is a third serial peripheral interface SPI 3.

Two ends of the enable control line 40 are coupled to the display driver integrated circuit DDIC and the touch integrated circuit TIC, and are configured to implement signal interworking between the display driver integrated circuit DDIC and the touch integrated circuit TIC.

In some embodiments, the enable control line 40 is a single signal line, and interfaces for coupling the display driver integrated circuit DDIC and the touch integrated circuit TIC to the enable control line 40 are input/output interfaces. That is, the display driver integrated circuit DDIC may transmit a signal to the touch integrated circuit TIC by using the enable control line 40, and the display driver integrated circuit DDIC may also receive, by using the enable control line 40, a signal transmitted by the touch integrated circuit TIC.

The enable control line 40 formed by the single signal line has a small quantity of lines and is easy to lay out.

In some other embodiments, as shown in FIG. 5, the enable control line 40 includes a first control line 41 and a second control line 42. Two ends of the first control line 41 are coupled to the display driver integrated circuit DDIC and the touch integrated circuit TIC, and two ends of the second control line 42 are coupled to the display driver integrated circuit DDIC and the touch integrated circuit TIC.

The enable control line 40 includes the first control line 41 and the second control line 42. A signal on each control line is a unidirectional transmission signal. This is easy to implement.

Ports that are in the display driver integrated circuit DDIC and the touch integrated circuit TIC and that are coupled to the first control line 41 may be, for example, idle general-purpose input/output GPIO interfaces in the display driver integrated circuit DDIC and the touch integrated circuit TIC, or may be newly added general-purpose input/output GPIO interfaces.

When the first control line 41 is valid, the touch integrated circuit TIC transmits, to the display driver integrated circuit DDIC, a first indication signal indicating that the touch integrated circuit TIC accesses the non-volatile memory 20, and after the display driver integrated circuit DDIC receives the first indication signal, the display driver integrated circuit DDIC controls the first communication interface (the first serial peripheral interface SPI 1) to be in a high-impedance state. When the first communication interface of the display driver integrated circuit DDIC is in a high-impedance state, the display driver integrated circuit DDIC and the non-volatile memory 20 are equivalent to being in an open-circuit state, there is no signal interworking between the display driver integrated circuit DDIC and the non-volatile memory 20, and the timing controller TCON does not access the non-volatile memory 20.

When the second control line 42 is valid, the display driver integrated circuit DDIC transmits, to the touch integrated circuit TIC, a second indication signal indicating that the timing controller TCON accesses the non-volatile memory 20, and after the touch integrated circuit TIC receives the second indication signal, the touch integrated circuit TIC controls the second communication interface (the second serial peripheral interface SPI 2) to be in a high-impedance state. When the second communication interface of the touch integrated circuit TIC is in a high-impedance state, the touch integrated circuit TIC and the non-volatile memory 20 are equivalent to being in an open-circuit state, there is no signal interworking between the touch integrated circuit TIC and the non-volatile memory 20, and the touch integrated circuit TIC does not access the non-volatile memory 20.

In this way, based on a signal transmitted on the enable control line 40, signal interworking between the display driver integrated circuit DDIC and the non-volatile memory 20 is selected and enabled, or signal interworking between the touch integrated circuit TIC and the non-volatile memory 20 is selected and enabled, and the display driver integrated circuit DDIC and the touch integrated circuit TIC do not affect each other, so that the timing controller TCON and the touch integrated circuit TIC share the non-volatile memory 20 in a time-sharing manner.

In some embodiments, the first communication interface (the first serial peripheral interface SPI 1) and the second communication interface (the second serial peripheral interface SPI 2) perform wire-AND.

For example, the first communication interface and the second communication interface perform wire-AND on the flexible printed circuit FPC.

In this way, a quantity of fifth communication interfaces (third serial peripheral interfaces SPIs 3) on the non-volatile memory 20 may be reduced, and one fifth communication interface may be coupled to both the first communication interface on the display driver integrated circuit DDIC and the second communication interface on the touch integrated circuit TIC.

In some embodiments, as shown in FIG. 5, the non-volatile memory 20 is disposed on the flexible printed circuit FPC.

For example, the non-volatile memory 20 is a flash memory.

In this way, a flash memory that is in a mainstream electronic device and that is coupled to the display driver integrated circuit DDIC may be used as the non-volatile memory 20 in the electronic device provided in embodiments of this application. A technical change is small, and implementation is easy.

In the electronic device provided in embodiments of this application, the timing controller TCON and the touch integrated circuit TIC are jointly designed to share the non-volatile memory 20. No flash memory is integrated into the touch integrated circuit TIC, and the touch integrated circuit TIC accesses the non-volatile memory 20 on the flexible printed circuit FPC by using the second communication interface. The display driver integrated circuit DDIC and the touch integrated circuit TIC interact with each other by using the enable control line 40. The enable control line 40 controls the display driver integrated circuit DDIC and the touch integrated circuit TIC to communicate with the non-volatile memory 20 in a time-sharing manner, so that the timing controller TCON and the touch integrated circuit TIC share the non-volatile memory 20, and the timing controller TCON and the touch integrated circuit TIC access the non-volatile memory 20 in a time-sharing manner. In this way, a non-volatile storage requirement of the touch integrated circuit TIC can also be ensured without integration of a flash memory into the touch integrated circuit TIC, to resolve a problem that a cost proportion of the flash memory is high (15% to 25%) because a specific technology compatible with a flash memory preparing process needs to be used to integrate the flash memory in the touch integrated circuit TIC, and resolve a problem that the touch integrated circuit TIC cannot be independently prepared because the flash memory needs to be purchased.

### Example 3

A difference between Example 3 and Example 1 and Example 2 lies in that, a non-volatile memory 20 is not disposed on a flexible printed circuit FPC, but is integrated into a display driver integrated circuit DDIC.

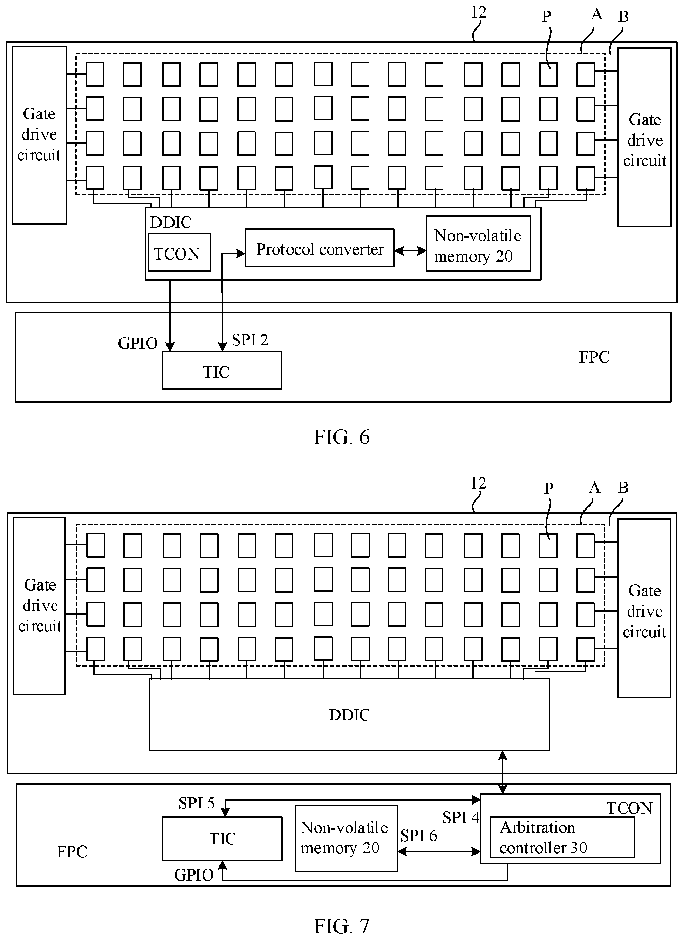

As shown in FIG. 6, an electronic device includes a touch display panel 12, the display driver integrated circuit DDIC, a timing controller TCON, a touch integrated circuit TIC, the flexible printed circuit FPC, and the non-volatile memory 20.

The timing controller TCON is integrated into the display driver integrated circuit DDIC, the non-volatile memory 20 is disposed outside the touch integrated circuit TIC, and the non-volatile memory 20 is configured to provide a non-volatile storage function for both the timing controller TCON and the touch integrated circuit TIC.

In some embodiments, the non-volatile memory 20 is integrated into the display driver integrated circuit DDIC.

In other words, in the electronic device provided in embodiments of this application, the non-volatile memory 20 that is configured to provide non-volatile storage space for the timing controller TCON and the touch integrated circuit TIC is integrated into the display driver integrated circuit DDIC, to replace a flash memory on a flexible printed circuit FPC in a conventional technology.

For example, as shown in FIG. 6, the electronic device further includes a protocol converter. The protocol converter is configured to match a communication interface of the touch integrated circuit TIC with a communication interface of the non-volatile memory 20, so that the touch integrated circuit TIC accesses the non-volatile memory 20.

In some embodiments, the touch integrated circuit TIC includes a serial peripheral interface (for example, a second serial peripheral interface SPI 2), and the non-volatile memory 20 includes a parallel memory interface (memory interface). The serial peripheral interface is coupled to the memory interface through the protocol converter, so that the touch integrated circuit TIC accesses the non-volatile memory 20 in the display driver integrated circuit DDIC by using the serial peripheral interface.

The timing controller TCON in the display driver integrated circuit DDIC may be directly coupled to the non-volatile memory 20 through, for example, the memory interface, and does not need to perform interface protocol conversion by using the protocol converter.

For example, as shown in FIG. 6, the protocol converter is integrated into the display driver integrated circuit DDIC.

In some embodiments, the non-volatile memory 20 is a non-volatile (non-volatile) memory (non-volatile memory).

For example, the non-volatile memory 20 is a read-only memory (read-only memory, ROM) or a flash memory (flash memory).

For example, the non-volatile memory 20 is a resistive non-volatile memory (resistive random access memory, RRAM).

In some embodiments, the timing controller TCON and the touch integrated circuit TIC may access the non-volatile memory 20 in a time-sharing manner.

For example, the display driver integrated circuit DDIC and the touch integrated circuit TIC are controlled to communicate with the non-volatile memory 20 in a time-sharing manner, so that the timing controller TCON and the touch integrated circuit TIC can access the non-volatile memory 20 in a time-sharing manner.

For example, the arbitration controller 30 shown in Example 1 is disposed in the display driver integrated circuit DDIC, and the arbitration controller 30 is used to schedule the timing controller TCON or the touch integrated circuit TIC to communicate with the non-volatile memory 20.

In this case, the arbitration controller 30 is used for the timing controller TCON and the touch integrated circuit TIC to access and be externally connected to the non-volatile memory 20 in a time-sharing manner. Under scheduling of the arbitration controller 30, at a moment, the timing controller TCON communicates with the non-volatile memory 20, or the touch integrated circuit TIC communicates with the non-volatile memory 20. A case in which the timing controller TCON and the touch integrated circuit TIC simultaneously communicate with the non-volatile memory 20 does not occur.

Alternatively, for example, the enable control line 40 shown in Example 2 is disposed between the display driver integrated circuit DDIC and the touch integrated circuit TIC, and the enable control line 40 is used to select and enable the timing controller TCON or the touch integrated circuit TIC to perform signal transmission with the non-volatile memory 20.

In this case, the enable control line 40 is configured to select and enable the timing controller TCON and the touch integrated circuit TIC to access and be externally connected to the non-volatile memory 20 in a time-sharing manner. Under control of an enable signal on the enable control line 40, at a moment, the timing controller TCON communicates with the non-volatile memory 20, or the touch integrated circuit TIC communicates with the non-volatile memory 20. A case in which the timing controller TCON and the touch integrated circuit TIC simultaneously communicate with the non-volatile memory 20 does not occur.

In some other embodiments, the timing controller TCON and the touch integrated circuit TIC may alternatively access the non-volatile memory 20 by area.

For example, the non-volatile memory 20 is divided into areas. The non-volatile memory 20 includes a first non-volatile storage area and a second non-volatile storage area. The first non-volatile storage area is configured to provide a non-volatile storage function for the timing controller TCON, and the second non-volatile storage area is configured to provide a non-volatile storage function for the touch integrated circuit TIC. In the non-volatile memory 20, an area for providing a non-volatile storage function for the timing controller TCON is separated from an area for providing a non-volatile storage function for the touch integrated circuit TIC, so that the timing controller TCON and the touch integrated circuit TIC access the non-volatile memory 20 by area.

In the electronic device provided in embodiments of this application, the timing controller TCON and the touch integrated circuit TIC are jointly designed to share the non-volatile memory 20. No flash memory is integrated into the touch integrated circuit TIC, and the non-volatile memory 20 is integrated into the display driver integrated circuit DDIC. The touch integrated circuit DDIC accesses, by using the serial peripheral interface, the non-volatile memory 20 integrated into the display driver integrated circuit DDIC, to replace a flash memory in the touch integrated circuit DDIC. In this way, a non-volatile storage requirement of the touch integrated circuit TIC can also be ensured without integration of a flash memory into the touch integrated circuit TIC, to resolve a problem that a cost proportion of the flash memory is high (15% to 25%) because a specific technology compatible with a flash memory preparing process needs to be used to integrate the flash memory in the touch integrated circuit TIC, and resolve a problem that the touch integrated circuit TIC cannot be independently prepared because the flash memory needs to be purchased.

In another possible implementation, the timing controller TCON is disposed on the flexible printed circuit FPC. For example, the electronic device is a large electronic device that does not have a particularly high integration requirement, for example, a notebook computer or a tablet.

### Example 4

A main difference between Example 4 and Example 1 lies in that, an arbitration controller 30 is not integrated into a display driver integrated circuit DDIC, but is integrated into a timing controller TCON.

As shown in FIG. 7, an electronic device includes a touch display panel 12, the display driver integrated circuit DDIC, a touch integrated circuit TIC, the timing controller TCON, a flexible printed circuit FPC, and a non-volatile memory 20.

The non-volatile memory 20 is disposed outside the touch integrated circuit TIC, and the non-volatile memory 20 is configured to provide a non-volatile storage function for both the timing controller TCON and the touch integrated circuit TIC.

The timing controller TCON is disposed on the flexible printed circuit FPC and is configured to provide a timing control signal for the display panel 12. The timing controller TCON is coupled to the display driver integrated circuit DDIC, to implement signal transmission between the timing controller TCON and the display driver integrated circuit DDIC.

In some embodiments, the electronic device further includes the arbitration controller 30. The arbitration controller 30 is configured to schedule the timing controller TCON or the touch integrated circuit TIC to communicate with the non-volatile memory 20.

In this case, the arbitration controller 30 is configured to control the timing controller TCON and the touch integrated circuit TIC to access and be externally connected to the non-volatile memory 20 in a time-sharing manner. Under scheduling of the arbitration controller 30, at a moment, the timing controller TCON communicates with the non-volatile memory 20, or the touch integrated circuit TIC communicates with the non-volatile memory 20. A case in which the timing controller TCON and the touch integrated circuit TIC simultaneously communicate with the non-volatile memory 20 does not occur.

In some embodiments, as shown in FIG. 7, the arbitration controller 30 is integrated into the timing controller TCON.

For example, the timing controller TCON has a fourth serial peripheral interface SPI 4, the touch integrated circuit TIC has a fifth serial peripheral interface SPI 5, and the non-volatile memory 20 has a sixth serial peripheral interface SPI 6. The touch integrated circuit TIC is coupled to the fourth serial peripheral interface SPI 4 of the timing controller TCON through the fifth serial peripheral interface SPI 5, to implement coupling between the touch integrated circuit TIC and the arbitration controller 30 in the timing controller TCON. The non-volatile memory 20 is coupled to the fourth serial peripheral interface SPI 4 of the timing controller TCON through the third serial peripheral interface SPI 3, to implement coupling between the non-volatile memory 20 and the arbitration controller 30 in the timing controller TCON.

In this way, the arbitration controller 30 is coupled to the touch integrated circuit TIC, the timing controller TCON, and the non-volatile memory 20. The arbitration controller 30 controls the touch integrated circuit TIC to communicate with the non-volatile memory 20, or the timing controller TCON to communicate with the non-volatile memory 20, to implement time-sharing reuse of the non-volatile memory 20.

For a structure of the arbitration controller 30, in some embodiments, the arbitration controller 30 is configured to: determine whether the timing controller TCON accesses the non-volatile memory 20; and when the timing controller TCON accesses the non-volatile memory 20, block the touch integrated circuit TIC from communicating with the non-volatile memory 20; or when the timing controller TCON does not access the non-volatile memory 20, schedule the touch integrated circuit TIC to communicate with the non-volatile memory 20.

Because the timing controller TCON needs to access the non-volatile memory 20 only in a power-on initialization process (for example, about 60 milliseconds), after power-on initialization, the timing controller TCON no longer needs to access the non-volatile memory 20. Therefore, when determining that the timing controller TCON does not access the non-volatile memory 20, the arbitration controller 30 schedules the touch integrated circuit TIC to communicate with the non-volatile memory 20.

In some embodiments, as shown in FIG. 7, the non-volatile memory 20 is disposed on the flexible printed circuit FPC.

For example, the non-volatile memory 20 is a flash memory.

In this way, a flash memory that is in a mainstream electronic device and that is coupled to the display driver integrated circuit DDIC may be used as the non-volatile memory 20 in the electronic device provided in embodiments of this application. A technical change is small, and implementation is easy.

In some embodiments, the timing controller TCON and the touch integrated circuit TIC are further coupled through a general-purpose input/output GPIO interface. Signal transmission may or may not be performed on the general-purpose input/output GPIO interface.

In the electronic device provided in embodiments of this application, the timing controller TCON and the touch integrated circuit TIC are jointly designed, so that the timing controller TCON and the touch integrated circuit TIC share the non-volatile memory 20. No flash memory is integrated into the touch integrated circuit TIC, and the touch integrated circuit TIC accesses the non-volatile memory 20 on the flexible printed circuit FPC by using the fifth serial peripheral interface SPI 5. The arbitration controller 30 controls the timing controller TCON and the touch integrated circuit TIC to communicate with the non-volatile memory 20 in a time-sharing manner, so that the timing controller TCON and the touch integrated circuit TIC share the non-volatile memory 20, and the timing controller TCON and the touch integrated circuit TIC access the non-volatile memory 20 in a time-sharing manner. In this way, a non-volatile storage requirement of the touch integrated circuit TIC can also be ensured without integration of a flash memory into the touch integrated circuit TIC, to resolve a problem that a cost proportion of the flash memory is high (15% to 25%) because a specific technology compatible with a flash memory preparing process needs to be used to integrate the flash memory in the touch integrated circuit TIC, and resolve a problem that the touch integrated circuit TIC cannot be independently prepared because the flash memory needs to be purchased.

### Example 5

A main difference between Example 5 and Example 2 lies in that, an arbitration controller 30 is not integrated into a display driver integrated circuit DDIC, but is integrated into a timing controller TCON.

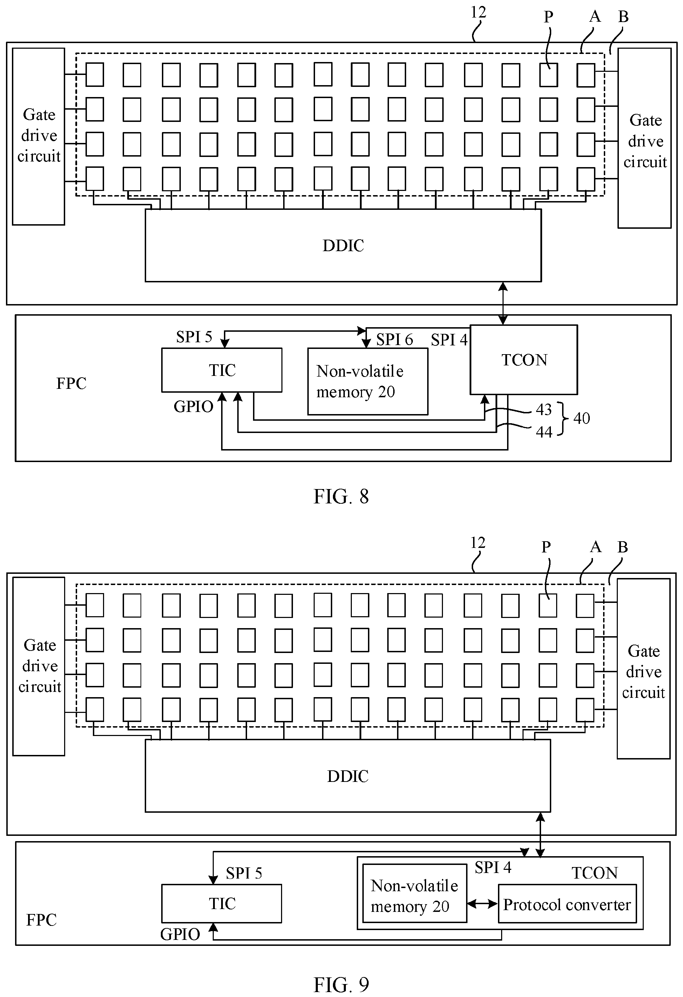

As shown in FIG. 8, an electronic device includes a touch display panel 12, the display driver integrated circuit DDIC, a touch integrated circuit TIC, the timing controller TCON, a flexible printed circuit FPC, and a non-volatile memory 20.

The non-volatile memory 20 is disposed outside the touch integrated circuit TIC, and the non-volatile memory 20 is configured to provide a non-volatile storage function for both the timing controller TCON and the touch integrated circuit TIC.

The timing controller TCON is disposed on the flexible printed circuit FPC and is configured to provide a timing control signal for the display panel 12. The timing controller TCON is coupled to the display driver integrated circuit DDIC, to implement signal transmission between the timing controller TCON and the display driver integrated circuit DDIC.

In some embodiments, the electronic device further includes an enable control line 40. The enable control line 40 is configured to select and enable the timing controller TCON or the touch integrated circuit TIC to perform signal transmission with the non-volatile memory 20.

In this case, the enable control line 40 is configured to select and enable the timing controller TCON and the touch integrated circuit TIC to access and be externally connected to the non-volatile memory 20 in a time-sharing manner. Under control of an enable signal on the enable control line 40, at a moment, the timing controller TCON communicates with the non-volatile memory 20, or the touch integrated circuit TIC communicates with the non-volatile memory 20. A case in which the timing controller TCON and the touch integrated circuit TIC simultaneously communicate with the non-volatile memory 20 does not occur.

In some embodiments, the timing controller TCON has a third communication interface, the touch integrated circuit TIC has a fourth communication interface, and the non-volatile memory 20 has a sixth communication interface. The non-volatile memory 20 is coupled to the third communication interface and the fourth communication interface through the sixth communication interface.

The third communication interface, the fourth communication interface, and the sixth communication interface are used as communication and interconnection interfaces between the touch integrated circuit TIC, the timing controller TCON, and the non-volatile memory 20. Communication connections between the touch integrated circuit TIC, the timing controller TCON, and the non-volatile memory 20 may be implemented through interconnection between the third communication interface, the fourth communication interface, and the sixth communication interface.

In this embodiment of this application, the third communication interface, the fourth communication interface, and the sixth communication interface have a function of being in a high-impedance (high-impedance) state.

For example, the fourth communication interface, the third communication interface, and the sixth communication interface are all serial peripheral interfaces. For example, as shown in FIG. 8, the third communication interface is a fourth serial peripheral interface SPI 4, the fourth communication interface is a fifth serial peripheral interface SPI 5, and the sixth communication interface is a sixth serial peripheral interface SPI 6.

Two ends of the enable control line 40 are coupled to the timing controller TCON and the touch integrated circuit TIC, and are configured to implement signal interworking between the timing controller TCON and the touch integrated circuit TIC.

In some embodiments, the enable control line 40 is a single signal line, and interfaces for coupling the timing controller TCON and the touch integrated circuit TIC to the enable control line 40 are input/output interfaces. That is, the timing controller TCON may transmit a signal to the touch integrated circuit TIC by using the enable control line 40, and the timing controller TCON may also receive, by using the enable control line 40, a signal transmitted by the touch integrated circuit TIC.

The enable control line 40 formed by the single signal line has a small quantity of lines and is easy to lay out.

In some other embodiments, as shown in FIG. 8, the enable control line 40 includes a third control line 43 and a fourth control line 44.

Two ends of the third control line 43 are coupled to the timing controller TCON and the touch integrated circuit TIC, and two ends of the fourth control line 44 are coupled to the timing controller TCON and the touch integrated circuit TIC.

The enable control line 40 includes the third control line 43 and the fourth control line 44. A signal on each control line is a unidirectional transmission signal. This is easy to implement.

Ports that are in the timing controller TCON and the touch integrated circuit TIC and that are coupled to the third control line 43 may be, for example, idle general-purpose input/output GPIO interfaces in the timing controller TCON and the touch integrated circuit TIC, or may be newly added general-purpose input/output GPIO interfaces.

When the third control line 43 is valid, the touch integrated circuit TIC transmits, to the timing controller TCON, a third indication signal indicating that the touch integrated circuit TIC accesses the non-volatile memory 20, and after the timing controller TCON receives the third indication signal, the timing controller TCON controls the third communication interface (the fourth serial peripheral interface SPI 4) to be in a high-impedance state. When the third communication interface of the timing controller TCON is in a high-impedance state, the timing controller TCON and the non-volatile memory 20 are equivalent to being in an open-circuit state, there is no signal interworking between the timing controller TCON and the non-volatile memory 20, and the timing controller TCON does not access the non-volatile memory 20.

When the fourth control line 44 is valid, the timing controller TCON transmits, to the touch integrated circuit TIC, a fourth indication signal indicating that the timing controller TCON accesses the non-volatile memory 20, and after the touch integrated circuit TIC receives the fourth indication signal, the touch integrated circuit TIC controls the fourth communication interface (the fifth serial peripheral interface SPI 5) to be in a high-impedance state. When the fourth communication interface of the touch integrated circuit TIC is in a high-impedance state, the touch integrated circuit TIC and the non-volatile memory 20 are equivalent to being in an open-circuit state, there is no signal interworking between the touch integrated circuit TIC and the non-volatile memory 20, and the touch integrated circuit TIC does not access the non-volatile memory 20.

In this way, based on a signal transmitted on the enable control line 40, signal interworking between the timing controller TCON and the non-volatile memory 20 is selected and enabled, or signal interworking between the touch integrated circuit TIC and the non-volatile memory 20 is selected and enabled, and the timing controller TCON and the touch integrated circuit TIC do not affect each other, to implement time-sharing reuse of the non-volatile memory 20.

In some embodiments, the third communication interface (the fourth serial peripheral interface SPI 4) and the fourth communication interface (the fifth serial peripheral interface SPI 5) perform wire-AND.

For example, the third communication interface and the fourth communication interface perform wire-AND on the flexible printed circuit FPC.

In this way, a quantity of sixth communication interfaces (sixth serial peripheral interfaces SPIs 6) on the non-volatile memory 20 may be reduced, and one sixth communication interface may be coupled to both the third communication interface on the display driver integrated circuit DDIC and the fourth communication interface on the touch integrated circuit TIC.

In some embodiments, as shown in FIG. 8, the non-volatile memory 20 is disposed on the flexible printed circuit FPC.

For example, the non-volatile memory 20 is a flash memory.

In this way, a flash memory that is in a mainstream electronic device and that is coupled to the timing controller TCON may be used as the non-volatile memory 20 in the electronic device provided in embodiments of this application. A technical change is small, and implementation is easy.

In the electronic device provided in embodiments of this application, the timing controller TCON and the touch integrated circuit TIC are jointly designed, so that the timing controller TCON and the touch integrated circuit TIC share the non-volatile memory 20. No flash memory is integrated into the touch integrated circuit TIC, and the touch integrated circuit TIC accesses the non-volatile memory 20 on the flexible printed circuit FPC by using the fourth communication interface. The timing controller TCON and the touch integrated circuit TIC interact with each other by using the enable control line 40. The enable control line 40 controls the timing controller TCON and the touch integrated circuit TIC to communicate with the non-volatile memory 20 in a time-sharing manner, so that the timing controller TCON and the touch integrated circuit TIC share the non-volatile memory 20, and the timing controller TCON and the touch integrated circuit TIC access the non-volatile memory 20 in a time-sharing manner. In this way, a non-volatile storage requirement of the touch integrated circuit TIC can also be ensured without integration of a flash memory into the touch integrated circuit TIC, to resolve a problem that a cost proportion of the flash memory is high (15% to 25%) because a specific technology compatible with a flash memory preparing process needs to be used to integrate the flash memory in the touch integrated circuit TIC, and resolve a problem that the touch integrated circuit TIC cannot be independently prepared because the flash memory needs to be purchased.

### Example 6

A main difference between Example 6 and Example 3 lies in that, a non-volatile memory 20 is not integrated into a display driver integrated circuit DDIC, but is integrated into a timing controller TCON.

As shown in FIG. 9, an electronic device includes a touch display panel 12, the display driver integrated circuit DDIC, a touch integrated circuit TIC, the timing controller TCON, a flexible printed circuit FPC, and the non-volatile memory 20.

The non-volatile memory 20 is disposed outside the touch integrated circuit TIC, and the non-volatile memory 20 is configured to provide a non-volatile storage function for both the timing controller TCON and the touch integrated circuit TIC.

In some embodiments, the timing controller TCON is disposed on the flexible printed circuit FPC, and the non-volatile memory 20 is integrated into the timing controller TCON.

In other words, in the electronic device provided in embodiments of this application, the non-volatile memory 20 that is configured to provide non-volatile storage space for the timing controller TCON and the touch integrated circuit TIC is integrated into the timing controller TCON, to replace a flash memory directly disposed on a flexible printed circuit FPC in a conventional technology.

For example, as shown in FIG. 9, the electronic device further includes a protocol converter. The protocol converter is configured to match a communication interface of the touch integrated circuit TIC with a communication interface of the non-volatile memory 20, so that the touch integrated circuit TIC accesses the non-volatile memory 20.

In some embodiments, the touch integrated circuit TIC includes a serial peripheral interface (for example, a fifth serial peripheral interface SPI 5), and the non-volatile memory 20 includes a memory interface. The serial peripheral interface (for example, the fifth serial peripheral interface SPI 5) of the touch integrated circuit TIC is coupled to a serial peripheral interface (for example, a fourth serial peripheral interface SPI 4) of the timing controller TCON, and then is coupled to the memory interface of the non-volatile memory 20 through the protocol converter, so that the touch integrated circuit TIC accesses the non-volatile memory 20 in the timing controller TCON by using the serial peripheral interface.

The timing controller TCON may be directly coupled to the non-volatile memory 20 through, for example, the memory interface, and the timing controller TCON is coupled to the non-volatile memory 20 without performing interface protocol conversion by using the protocol converter.

For example, as shown in FIG. 9, the protocol converter is integrated into the timing controller TCON.

In some embodiments, the non-volatile memory 20 is a read-only memory or a flash memory. For example, the non-volatile memory 20 is a resistive non-volatile memory.

In some embodiments, the timing controller TCON and the touch integrated circuit TIC may access the non-volatile memory 20 in a time-sharing manner.

For example, the arbitration controller 30 shown in Example 4 is disposed in the timing controller TCON, and the arbitration controller 30 is used to schedule the timing controller TCON or the touch integrated circuit TIC to communicate with the non-volatile memory 20.

In this case, the arbitration controller 30 is configured to control the timing controller TCON and the touch integrated circuit TIC to access and be externally connected to the non-volatile memory 20 in a time-sharing manner. Under scheduling of the arbitration controller 30, at a moment, the timing controller TCON communicates with the non-volatile memory 20, or the touch integrated circuit TIC communicates with the non-volatile memory 20. A case in which the timing controller TCON and the touch integrated circuit TIC simultaneously communicate with the non-volatile memory 20 does not occur.

Alternatively, for example, the enable control line 40 shown in Example 5 is disposed between the timing controller TCON and the touch integrated circuit TIC, and the enable control line 40 is used to select and enable the timing controller TCON or the touch integrated circuit TIC to perform signal transmission with the non-volatile memory 20.

In this case, the enable control line 40 is configured to select and enable the timing controller TCON and the touch integrated circuit TIC to access and be externally connected to the non-volatile memory 20 in a time-sharing manner. Under control of an enable signal on the enable control line 40, at a moment, the timing controller TCON communicates with the non-volatile memory 20, or the touch integrated circuit TIC communicates with the non-volatile memory 20. A case in which the timing controller TCON and the touch integrated circuit TIC simultaneously communicate with the non-volatile memory 20 does not occur.

In some other embodiments, the timing controller TCON and the touch integrated circuit TIC may alternatively access the non-volatile memory 20 by area.

For example, the non-volatile memory 20 is divided into areas. The non-volatile memory 20 includes a first non-volatile storage area and a second non-volatile storage area. The first non-volatile storage area is configured to provide a non-volatile storage function for the timing controller TCON, and the second non-volatile storage area is configured to provide a non-volatile storage function for the touch integrated circuit TIC. In the non-volatile memory 20, an area for providing a non-volatile storage function for the timing controller TCON is separated from an area for providing a non-volatile storage function for the touch integrated circuit TIC, so that the timing controller TCON and the touch integrated circuit TIC access the non-volatile memory 20 by area.

In the electronic device provided in embodiments of this application, the timing controller TCON and the touch integrated circuit TIC are jointly designed, so that the timing controller TCON and the touch integrated circuit TIC share the non-volatile memory 20. No flash memory is integrated into the touch integrated circuit TIC, and the non-volatile memory 20 is integrated into the timing controller TCON. The touch integrated circuit DDIC accesses, by using the serial peripheral interface, the non-volatile memory 20 integrated into the timing controller TCON, to replace a flash memory in the touch integrated circuit DDIC. In this way, a non-volatile storage requirement of the touch integrated circuit TIC can also be ensured without integration of a flash memory into the touch integrated circuit TIC, to resolve a problem that a cost proportion of the flash memory is high (15% to 25%) because a specific technology compatible with a flash memory preparing process needs to be used to integrate the flash memory in the touch integrated circuit TIC, and resolve a problem that the touch integrated circuit TIC cannot be independently prepared because the flash memory needs to be purchased.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An electronic device, comprising:
a touch display panel;
a timing controller, configured to provide a timing control signal for the touch display panel;
a circuit board, coupled to the touch display panel;
a touch integrated circuit, disposed on the circuit board, and configured to provide a touch signal for the touch display panel; and
a non-volatile memory, disposed outside the touch integrated circuit, wherein the non-volatile memory is configured to provide a non-volatile storage function for both the timing controller and the touch integrated circuit.

2. The electronic device according to claim 1, wherein the electronic device further comprises an arbitration controller, and the arbitration controller is configured to schedule the timing controller or the touch integrated circuit to communicate with the non-volatile memory.

3. The electronic device according to claim 2, wherein the arbitration controller is configured to: determine whether the timing controller accesses the non-volatile memory; and when the timing controller accesses the non-volatile memory, block the touch integrated circuit from communicating with the non-volatile memory; or when the timing controller does not access the non-volatile memory, schedule the touch integrated circuit to communicate with the non-volatile memory.

4. The electronic device according to claim 2 or 3, wherein the electronic device comprises a display driver integrated circuit, and the timing controller and/or the arbitration controller are/is integrated into the display driver integrated circuit.

5. The electronic device according to claim 2 or 3, wherein the timing controller is disposed on the circuit board, and the arbitration controller is integrated into the timing controller.

6. The electronic device according to claim 1, wherein the electronic device further comprises an enable control line, and the enable control line is configured to select and enable the timing controller or the touch integrated circuit to perform signal transmission with the non-volatile memory.

7. The electronic device according to claim 6, wherein the electronic device comprises a display driver integrated circuit, and the timing controller is integrated into the display driver integrated circuit;
the display driver integrated circuit has a first communication interface, the touch integrated circuit has a second communication interface, and the non-volatile memory is coupled to the first communication interface and the second communication interface; and
two ends of the enable control line are coupled to the display driver integrated circuit and the touch integrated circuit, and the enable control line comprises a first control line and a second control line; and when the first control line is valid, the display driver integrated circuit controls the first communication interface to be in a high-impedance state; or when the second control line is valid, the touch integrated circuit controls the second communication interface to be in a high-impedance state.

8. The electronic device according to claim 7, wherein the first communication interface and the second communication interface perform wire-AND.

9. The electronic device according to claim 6, wherein the timing controller is disposed on the circuit board;
the timing controller has a third communication interface, the touch integrated circuit has a fourth communication interface, and the non-volatile memory is coupled to the third communication interface and the fourth communication interface; and
two ends of the enable control line are coupled to the timing controller and the touch integrated circuit, and the enable control line comprises a third control line and a fourth control line; and when the third control line is valid, the timing controller controls the third communication interface to be in a high-impedance state; or when the fourth control line is valid, the touch integrated circuit controls the fourth communication interface to be in a high-impedance state.

10. The electronic device according to claim 9, wherein the third communication interface and the fourth communication interface perform wire-AND.

11. The electronic device according to any one of claims 7 to 10, wherein the first communication interface, the second communication interface, the third communication interface, and the fourth communication interface are all serial peripheral interfaces.

12. The electronic device according to any one of claims 1 to 11, wherein the non-volatile memory comprises a flash memory.

13. The electronic device according to any one of claims 1 to 12, wherein the non-volatile memory is disposed on the circuit board.

14. The electronic device according to claim 1, wherein the electronic device comprises a display driver integrated circuit, and the timing controller and the non-volatile memory are integrated into the display driver integrated circuit.

15. The electronic device according to claim 1, wherein the timing controller is disposed on the circuit board, and the non-volatile memory is integrated into the timing controller.

16. The electronic device according to claim 14 or 15, wherein the electronic device further comprises a protocol converter, and the protocol converter is configured to match a communication interface of the touch integrated circuit with a communication interface of the non-volatile memory.

17. The electronic device according to claim 16, wherein the touch integrated circuit comprises a serial peripheral interface, the non-volatile memory comprises a memory interface, and the serial peripheral interface is coupled to the memory interface through the protocol converter.

18. The electronic device according to any one of claims 14 to 17, wherein the protocol converter is integrated into the display driver integrated circuit or the timing controller.

19. The electronic device according to any one of claims 14 to 18, wherein the non-volatile memory comprises a first non-volatile storage area and a second non-volatile storage area, the first non-volatile storage area is configured to provide a non-volatile storage function for the timing controller, and the second non-volatile storage area is configured to provide a non-volatile storage function for the touch integrated circuit.
